# FASCICULE DE BREVET EUROPEEN

(11) **EP 0 531 184 B1**
(45) Date de publication et mention de la délivrance du brevet: **14.06.1995**
(21) Numéro de dépôt: 92402274.2
(22) Date de dépôt: 12.08.1992
(51) Int. Cl.: B60Q 1/26, F21Q 1/00, H01L 25/075

(54) **Elément optique de collimation et son élément de support associé, notamment pour feu de signalisation de véhicule automobile**
Optisches Kollimationselement mit entsprechendem Trägerteil, insbesondere für Kfz-Signalleuchten
Optical collimating element with its supporting structure, especially for signalling lights of motor vehicles

(30) Priorité: 02.09.1991 FR 9110836
(43) Date de publication de la demande: 10.03.1993
(73) Titulaire: VALEO VISION, 93012 Bobigny Cédex (FR)
(72) Inventeur: Louy, Jean-François, F-75016 Paris (FR); Gasquet, Jean Claude, F-89100 Saint-Clement (FR)
(74) Mandataire: Lemaire, Marc

(56) Documents cités:
- DE-A- 3 929 125
- FR-A- 2 563 929

## Description

La présente invention concerne d'une manière générale un élément optique de collimation pour feu de signalisation, notamment pour véhicule automobile. Elle concerne également l'élément de support associé à un tel élément optique de collimation.

Ainsi qu'on le sait un feu de signalisation de conception classique se présente sous la forme d'un bloc comprenant au moins un réflecteur, dans lequel est montée une lampe à incandescence ou fluorescence, une glace transparente ou globe étant montée dans le réflecteur.

Un tel feu est relativement épais et pose des problèmes d'adaptation au support sur lequel il doit être monté, notamment la région du coin du véhicule ou une aile de celui-ci. D'une manière générale les ampoules sont fragiles, ont une durée de vie relativement courte et sont consommatrices d'énergie.

Pour cette raison on a déjà proposé de réaliser des feux de signalisation compacts en utilisant comme source lumineuse un ensemble d'émetteur de lumière à semi-conducteur, tel que des diodes électroluminescentes.

Ces réalisations permettent de pallier les inconvénients précités des feux classiques et offrent la possibilité de disposer, par exemple, des diodes éclairantes dans les deux couleurs, rouge et orange, utilisées pour la signalisation automobile, tout en étant incolores à l'état éteint, ce qui permet d'obtenir un feu d'aspect régulier.

Un tel feu est décrit par exemple dans le document FR-A-2 574 616 (US-A-4 742 432) (correspondant au préambule de la revendication 1).

Dans celui-ci les diodes électroluminescentes sont montées sur un élément de support plan revêtu par un circuit électronique à composants multiples, un élément optique de collimation étant monté sur lesdites diodes. En pratique cet élément optique de collimation présente une pluralité de cavités paraboliques réfléchissantes se prolongeant par des ouvertures cylindriques isolantes venant s'engager à faible jeu dans des rondelles conductrices appartenant aux diodes, jusqu'à ce que la face inférieure isolante dudit élément optique vienne en butée sur le support.

Lorsque le feu est de forme gauche non plane, il faut conformer en conséquence ledit élément de collimation pour les diodes électroluminescentes formant alors un réseau tridimensionnel.

Un problème se pose alors car il faut trouver une nouvelle forme pour ledit élément optique de collimation afin que le rendement optique du feu demeure toujours excellent. En effet, il faut que les diodes électroluminescentes soient placées en des endroits judicieux pour avoir un bon éclairage.

En outre il faut que ledit élément optique soit robuste et de fabrication simple.

La présente invention a pour objet de résoudre ces problèmes.

Suivant l'invention, un élément optique de collimation du type sus-indiqué, est caractérisé en ce que sa face dorsale est conformée en gradins dans lesquels débouchent des ouvertures traversantes associées aux diodes électroluminescentes.

Grâce à l'invention, l'élément optique de collimation est robuste et il est possible de placer les diodes au bon endroit, lesdites diodes étant avantageusement portées par des lanières appartenant à l'élément de support, que comporte usuellement ledit feu de signalisation. Ainsi les diodes peuvent être prises en sandwich entre les lanières et les gradins, en sorte qu'il est possible de placer les diodes à l'endroit judicieux, notamment au foyer ou centre optique des ouvertures de l'élément de collimation, et ce malgré la forme gauche du feu de signalisation.

En outre la fabrication de l'élément optique de collimation est aisée, celui-ci étant obtenu facilement par moulage.

Grâce à la présente invention, on peut conserver un mode de montage de composants simples à plat pour réaliser un circuit tridimensionnel.

Il peut y avoir une unicité de technologie de montage de composants additionnels intégrés dans le feu pour obtenir des fonctionnalités telles que multiplexage de la commande d'allumage du feu, affichage de signe ou texte par allumage convenable des sources lumineuses discrètes.

L'invention permet ainsi une bonne aptitude au positionnement des sources lumineuses avec la précision requise par leur alignement optique vis-à-vis de l'enveloppe externe du feu de signalisation.

La position desdites sources lumineuses peut être calculée par ordinateur avec indexage physique au moyen de crans, d'encoches ou autres réalisés le long des lanières.

La description qui va suivre illustre l'invention, dans le cadre d'un feu de signalisation pour véhicule automobile, en regard des dessins annexés dans lesquels :
- la figure 1 est une vue frontale schématique de l'élément optique de collimation associé à l'élément de support selon l'invention;
- la figure 2 est une vue schématique de l'élément de support équipé après découpe de ses lanières;
- la figure 3 est une vue analogue à la figure 2, après déformation permanente des lanières;
- la figure 4 est une vue en coupe selon la ligne 4-4 de la figure 1;
- la figure 5 est une vue en coupe schématique selon ligne 5-5 de la figure 1;
- la figure 6 est une vue selon la flèche 6 de la figure 2 montrant une diode électroluminescente;
- la figure 7 est une variante de réalisation de la figure 2.

Dans ces figures, est illustré un élément de support 4 équipé d'un circuit électronique à composants multiples 2,3 pour feu de signalisation, de véhicule automobile, de forme non plane et gauche selon l'invention.

Cet élément de support 4 porte des sources lumineuses 3 discrètes sous la forme d'éléments électroluminescents discrets ou éléments optoélectroniques discrets. Ces éléments électroluminescents seront appelés par la suite diodes électroluminescentes.

De même, par élément de support ou support isolant, on entend ici une pièce en un matériau électriquement isolant tel que les éléments 1,4 et le support 6 décrit ci-après.

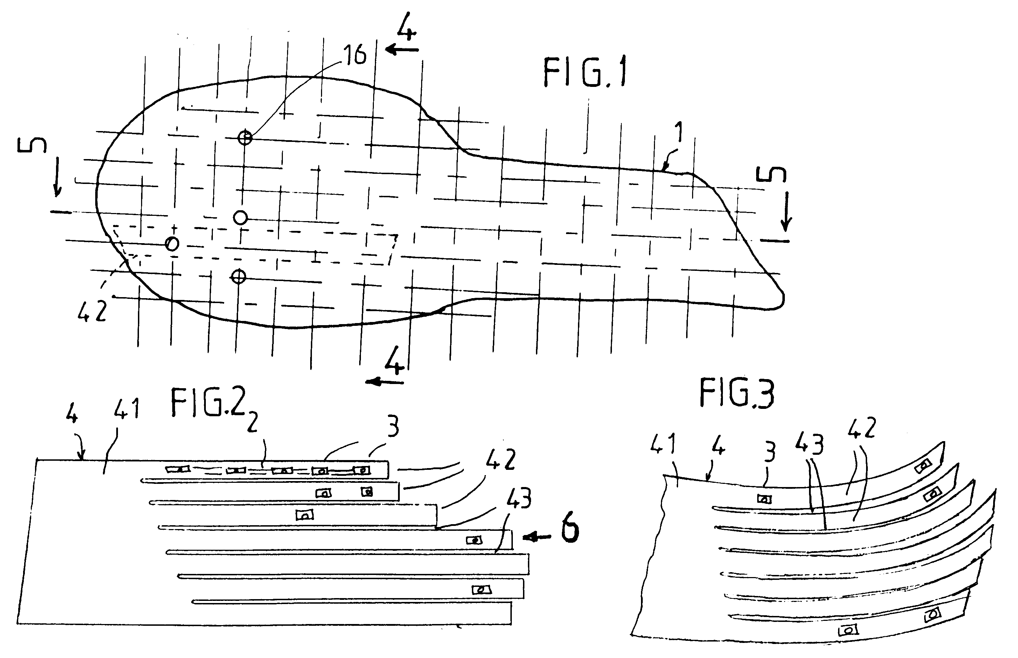

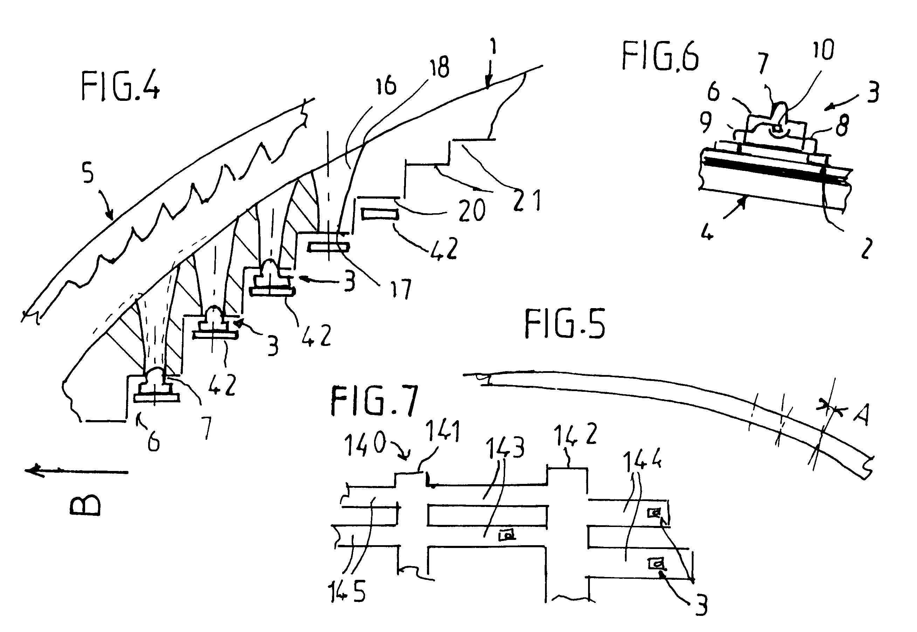

Comme visible à la figure 1 du document FR-A-2481563, et à la figure 6 de la présente demande, chaque diode électroluminescente 3 comporte un support 6 portant des bornes d'alimentation électriques 8,9, un émetteur de lumière proprement dit à semi-conducteur 10 et un encapsulage 7 saillant, à tête pénétrante, entourant ledit émetteur de lumière 10. Ici l'une des bornes d'alimentation, à savoir la borne 8, est une cathode présentant un réflecteur entourant le cristal 10, tandis que l'autre borne d'alimentation 9 est une anode. Ces bornes 8,9 sont ici en majeure partie noyées dans le support 6, ici électriquement isolant.

Un élément de collimation 1, ici en matière électriquement isolante, est associé à l'élément de support 4 et a comme celui-ci une forme gauche, lesdits éléments 1,4 ayant une forme s'adaptant l'un à l'autre. Cet élément de collimation 1 présente, en regard de chaque encapsulage 7, une ouverture 16 traversante, avec formation d'un réseau tridimensionnel de diodes 3 et d'ouvertures 16.

Un circuit électrique 2 est prévu pour alimentation électrique et interconnexion des bornes d'alimentation 8,9 et donc des diodes 3. Ce circuit électrique 2 appartient au circuit électronique porté par l'élément de support 4, plus précisément par la face frontale de celui-ci tournée vers l'élément de collimation 1.

L'élément de support 4 est donc revêtu par le circuit électrique 2 réalisé par exemple par sérigraphie (dépôt d'encre conductrice sur la face frontale de l'élément 4) ou en variante par dépôt électrochimique ou électrolytique.

On peut également réaliser, comme décrit dans le document FR-A-2 601 486 (EP-A-0 253 244), le circuit électrique à l'aide d'un film souple rapporté par collage sur la face frontale de l'élément 4 au moyen d'une pellicule adhésive, ledit film portant un revêtement cuivré et étamé.

Une telle disposition est visible à la figure 6, la pellicule adhésive étant représentée en sombre.

Suivant une caractéristique de l'invention, un élément de support 4 équipé d'un circuit électronique à composants multiples 2,3 du type sus-indiqué est caractérisé en ce qu'il comporte des lanières 42 séparées les unes des autres.

Dans le mode de réalisation de la figure 2, l'élément de support 4 équipé a globalement la forme d'un peigne avec des lanières 42 séparées les unes des autres par des fentes 43. Ces lanières 42 se raccordent à une racine commune 41, que présente ledit élément de support 4 équipé à l'une de ses extrémités.

Le procédé de fabrication d'un tel élément de support est caractérisé en ce que, partant d'un élément de support 4 équipé de son circuit électronique à composants multiples 2,3, on refend de multiples fois sur une partie de sa longueur ledit élément 4, de manière à constituer des lanières 42 restant attachées par au moins une de leurs extrémités à une racine 41 dudit élément.

A la figure 2, les lanières 42 sont attachées à l'une de leurs extrémités à la racine 41, tandis que l'autre de leurs extrémités est libre.

Ainsi dans une deuxième étape on déforme de manière permanente les lanières 42 dont la longueur a été calculée pour que, une fois mise en forme, elles s'alignent selon une courbe définie sur leur surface gauche associée, ici des bandes 20 décrites ci-après de l'élément 1.

Ici les fentes 43 et les lanières 42 sont réalisées par sciage mécanique ou à l'aide d'un procédé laser ou par massicotage ou par découpe à l'emporte-pièce.

L'élément de collimation 1 présente, suivant une caractéristique, des bandes 20 pour s'adapter aux lanières 42. Plus précisément, un élément optique de collimation du type sus-indiqué est caractérisé en ce que sa face dorsale est conformée en gradins 21 dans lesquels débouchent des ouvertures traversantes 16 associées aux diodes électroluminescentes 3.

Comme visible à la figure 4, les bandes 20 appartiennent aux gradins 21 et constituent la partie horizontale de ceux-ci en référence à la figure 4. Ces bandes 20 sont séparées par des parois verticales (voir figure 4). Les bandes 20 forment donc des ressauts. Ce sont ces bandes 20 qui supportent les diodes 3. L'élément 1 a donc une fonction optique et mécanique en étant robuste.

La largeur des bandes 20 est donc adaptée à la largeur des lanières 42, la largeur des bandes 20 étant ici supérieure à la largeur des lanières 42. Ainsi la face dorsale, tournée vers l'élément 4 et vers les lanières 42 (figure 4) de cet élément de collimation 1 est conformée en gradins 21.

Ici les ouvertures 16 sont traversantes et leur extrémité dorsale 17 dépend de la taille de l'encapsulage 7. Ledit encapsulage pouvant être monté à jeu ou sans jeu dans ladite ouverture évasée 16. Les ouvertures 16 débouchent donc dans les bandes 20, leur extrémité frontale 18 étant de taille supérieure à leur extrémité dorsale 17.

On appréciera que l'extrémité dorsale 17 de l'ouverture 16 est associée à chaque encapsulage 7 en sorte que l'on peut monter aisément l'encapsulage 7 dans l'ouverture 16 sans être gêné. Ici cet encapsulage 7 à forme pénétrante a globalement la forme d'une ogive, mais bien entendu elle pourrait être en forme de demi-olive ou autre. La forme de sa tête étant telle qu'elle permet un montage aisé et un centrage dans l'ouverture 16 associée.

L'encapsulage 7 s'érige en saillie à partir de la face frontale du support 6 par exemple de forme cylindrique ou rectangulaire.

Les diodes 3 ont donc une structure compacte et économique, la largeur des lanières 42 étant adaptée à la dimension des diodes et'autres composants électroniques portés par l'élément de support 4. Les diodes 3 ou autres composants électroniques étant installés dans des zones destinées dès le départ à devenir des lanières.

Le circuit 2 est donc à l'image de l'élément de support 4 et présente des lanières.

La fixation des éléments 3 se fait par exemple par soudage par exemple dans un four à refusion ou par soudage à la vague. On peut également procéder à la fixation à l'aide d'une pâte collante conductrice qui se polymérise par la suite. Tout autre mode de fixation est envisageable, tel que fixation par chauffage à induction ou fixation par chauffage à micro-onde, car, grâce à l'invention, tous les composants électroniques se montent aisément en surface lorsque l'élément de support 4 est plan avant sa déformation.

On notera que l'élément de support 4 est isolant et qu'il est par exemple en matière plastique.

D'une manière générale ce support 4 est semi-rigide. Bien entendu, l'élément de support 4 peut être un substrat métallique isolé. Cet élément 4 est propre à être fixé à la carrosserie du véhicule automobile, soit directement ou soit indirectement.

L'élément optique de collimation est en matière isolante et a donc une forme gauche avec une multitude d'ouvertures 16 dont on voit à la figure 1 les axes de symétrie. Les ouvertures 16 forment donc un réseau tridimensionnel d'ouvertures.

L'élément 1 ici bombé présente une face frontale revêtue d'un revêtement réfléchissant ainsi qu'un alésage interne des ouvertures 16.

Le revêtement est avantageusement à base d'aluminium. Cet élément 1 est opaque et est réalisé avantageusement en matière plastique. Cet élément 1 est robuste et consiste donc en un réflecteur conformé en guide de lumière avec des faces dorsales et frontales spécialisées, la face frontale ayant une fonction optique, tandis que la face dorsale a une fonction mécanique de support.

Ici les bandes 20 ont une surface de forme cylindrique et elles s'étendent toutes parallèlement en section dans une direction commune B (voir figure 4).

Les lanières 42 ont donc ici également une forme cylindrique après leur déformation à l'aide d'un outil approprié, lorsque l'élément 4 est souple ou à l'aide de l'élément optique 1, lorsque l'élément 4 est semi-rigide.

On appréciera que la fabrication de l'élément 1 est aisée, le démoulage des ouvertures 16 ne posant aucun problème, lesdites ouvertures 16 étant de forme évasée telles que définie par une conique de révolution; une conique étant une courbe (ellipse, parabole, hyperbole par exemple) correspondant au lieu géométrique des points dont le rapport des distances à un point dit foyer et à une droite dite directrice, a une valeur donnée.

La taille de l'extrémité frontale 18 des ouvertures 16 varie selon leur position sur le feu. Bien entendu on peut espacer plus ou moins les ouvertures 16 en fonction de leur position sur le feu pour avoir le meilleur rendement optique.

Comme visible à la figure 5, les axes des ouvertures 16 peuvent être inclinés d'un angle A selon leur position sur le feu.

Les diodes 3 forment globalement une matrice et un réseau tridimensionnel de diodes tels que visible à la figure 1.

Les diodes 3 peuvent émettre en couleur rouge ou en couleur orange, le transparent 5 pouvant être teinté ou présenter des couleurs ambres ou rouges selon les desiderata des constructeurs.

Le circuit électronique selon l'invention peut comporter également des composants de puissance, des éléments de connectique, des microprocesseurs, des composants émetteur et/ou récepteur de rayonnement infrarouge.

Ainsi il est possible de réaliser un multiplexage de la commande d'allumage des feux, un affichage de signe de texte par l'allumage convenable des diodes 3.

Ainsi qu'on l'aura compris et qu'il ressort à l'évidence de la description et des dessins, les diodes 3 viennent se placer exactement au foyer des ouvertures 16, en sorte que le feu selon l'invention a de grandes performances optiques. Les diodes 3 étant prises en sandwich après déformation des lanières 42, entre les lanières 42 et les bandes 20 de l'élément optique de collimation.

Ici cet élément optique est revêtu par un élément transparent 5 qui peut être de couleur fumée ou être de plusieurs couleurs, par exemple ambre et rouge selon les souhaits du constructeurs.

Bien entendu la présente invention n'est pas limitée à l'exemple de réalisation décrit. En particulier les lanières 42 peuvent s'étendre dans les deux sens par rapport à la racine 41 dont la position peut dépendre des applications. Ici la racine 41 est disposée à l'extrémité du support 4, mais bien entendu elle peut être disposée au milieu de celui-ci.

Bien entendu, l'élément de support peut être doté de plusieurs racines. Ainsi par exemple, tel que représenté à la figure 7, l'élément 140 peut présenter deux racines 141,142 avec trois jeux de lanières 145,143,144. Les lanières 143 s'étendent entre les deux racines 142, tandis que les lanières 144 et 145 ont des extrémités libres et s'étendent en porte-à-faux par rapport aux racines 142,141.

Tout ceci dépend de la forme du feu. La largeur des lanières pouvant être évolutive de même que leur longueur (voir par exemple les lanières 144 de la figure 7). La largeur peut varier d'une lanière à l'autre.

Les bandes 20 et les lanières 42 peuvent s'étendre horizontalement comme à la figure 1 ou verticalement ou obliquement.

L'élément de support 4 peut être obtenu par moulage et être dépourvu de lanières 42 en étant à l'image de l'élément optique de collimation 1, c'est-à-dire en étant pourvu, en regard des gradins 21 de l'élément 1, de gradins complémentaires auxdits gradins 21.

L'élément optique 1 peut servir à la fixation du feu sur la carrosserie du véhicule. Il peut être par exemple de forme creuse en étant pourvu sur sa face dorsale d'un rebord périphérique enveloppant l'élément de support 4 en étant pourvu de moyens de fixation sur la carrosserie du véhicule. Dans ce cas, l'élément de support 4 est fixé par sa racine ou ses racines 41-141,142 audit élément optique 1.

Bien entendu, l'élément de support 4 peut être également de forme creuse en ayant sur sa face dorsale un rebord de fixation pour la fixation du feu à la carrosserie du véhicule. Dans ce cas, son fond est fractionné en lanières entouré par ledit rebord de fixation.

L'élément optique de collimation vient alors se fixer sur ledit élément 4 (à la faveur dudit rebord de fixation), ainsi que le transparent.

Ainsi qu'il ressort à l'évidence de la description et des dessins, l'élément de support 4 est avantageusement en matériau semi-rigide. Dans ce cas, l'élément optique de collimation 1 constitue un gabarit pour ledit élément 4, les lanières 42 se déformant et épousant la forme des bandes 20 par coopération des diodes 3 avec les bandes 20.

Bien entendu, l'élément de support 4 peut être en matériau plus souple et dans ce cas il faut un gabarit spécifique pour le conformer.

## Revendications

1. Elément optique de collimation (1) pour feu de signalisation, notamment pour véhicule automobile, propre à être associé à un élément de support (4) portant des diodes électroluminescentes (3), du genre comportant une face dorsale pour coopération avec lesdites diodes électroluminescentes (3), caractérisé en ce que sa face dorsale est conformée en gradins (21), dans lesquels débouchent des ouvertures traversantes (16) associées aux diodes électroluminescentes (3).

2. Elément optique de collimation (1) selon la revendication 1, caractérisé en ce que les gradins (21) comportent des bandes (20), dans lesquels débouchent lesdites ouvertures (16).

3. Elément optique de collimation (1) selon la revendication 2, caractérisé en ce que les bandes (20) ont une surface de forme cylindrique et s'étendent toutes parallèlement en section à une direction commune.

4. Elément optique de collimation (1) selon l'une quelconque des revendications 1 à 3, caractérisé en ce que les ouvertures (16) ont une forme évasée.

5. Elément de support (4) associé à un élément optique de collimation selon l'une quelconque des revendications 2 et 3, caractérisé en ce qu'il comporte des lanières (42) pour support des diodes électroluminescentes (3), la taille desdites lanières (42) étant adaptée à celle des bandes (20) de l'élément optique de collimation (1).

6. Elément de support (4) selon la revendication 5, caractérisé en ce que les diodes électroluminescentes (3) sont prises en sandwich entre lesdites bandes (20) de l'élément optique de collimation (1), et les lanières (42) dudit élément de support.

## Claims

1. An optical collimating element (1) for a signal lamp display, in particular for a motor vehicle, adapted to be associated with a support element (4) carrying light emitting diodes (3), of the kind having a back face for cooperation with the said light emitting diodes (3), characterised in that its back face is formed in steps (21), into which a plurality of through holes (16), associated with the light emitting diodes (3), are open.

2. An optical collimating element (1) according to Claim 1, characterised in that the steps (21) comprise bands (20) into which the said holes (16) are open.

3. An optical collimating element (1) according to Claim 2, characterised in that the bands (20) have a cylindrical surface, and all of them extend parallel, in cross section, to a common direction.

4. An optical collimating element (1) according to any one of Claims 1 to 3, characterised in that the holes (16) have a flared shape.

5. A support element (4) associated with an optical collimating element according to either one of Claims 2 and 3, characterised in that it includes strips (42) for supporting the light emitting diodes (3), with the size of the said strips (42) being adapted to that of the bands (20) of the optical collimating element (1).

6. A support element (4) according to Claim 5, characterised in that the light emitting diodes (3) are sandwiched between the said bands (20) of the optical collimating element (1) and the strips (42) of the said support element.

## Patentansprüche

1. Optisches Kollimationselement (1) für Signalleuchten, insbesondere für Kraftfahrzeuge, das mit einem Trägerteil (4) mit darauf befindlichen Lumineszenzdioden (3) verbunden werden kann, in der Ausführung mit einer Rückseite für das Zusammenwirken mit den genannten Lumineszenzdioden (3), **dadurch gekennzeichnet**, daß seine Rückseite in Form von Stufen (21) ausgebildet ist, in welche durchgehende Öffnungen (16) einmünden, die den Lumineszenzdioden (3) zugeordnet sind.

2. Optisches Kollimationselement (1) nach Anspruch 1, **dadurch gekennzeichnet**, daß die Stufen (21) Leisten (20) umfassen, in welche die genannten Öffnungen (16) einmünden.

3. Optisches Kollimationselement (1) nach Anspruch 2, **dadurch gekennzeichnet**, daß die Leisten (20) eine Oberfläche mit zylindrischer Form besitzen und sich alle parallel im Schnitt in einer gemeinsame Richtung erstrecken.

4. Optisches Kollimationselement (1) nach einem der Ansprüche 1 bis 3, **dadurch gekennzeichnet**, daß die Öffnungen (16) trichterförmig ausgebildet sind.

5. Trägerteil (4), das zu einem optischen Kollimationselement nach einem der Ansprüche 2 und 3 gehört , **dadurch gekennzeichnet**, daß es Streifen (42) zur Anbringung der Lumineszenzdioden (3) umfaßt, wobei die Größe der genannten Streifen (42) auf die Größe der Leisten (20) des optischen Kollimationselements (1) abgestimmt ist.

6. Trägerteil (4) nach Anspruch 5, **dadurch gekennzeichnet**, daß die Lumineszenzdioden (3) in Sandwich-Bauweise zwischen den genannten Leisten (20) des optischen Kollimationselements (1) und den Streifen (42) des genannten Trägerteils eingesetzt sind.
